# EUROPÄISCHE PATENTSCHRIFT

(11) **EP 3 485 508 B1**
(45) Veröffentlichungstag und Bekanntmachung des Hinweises auf die Patenterteilung: **02.09.2020**
(21) Anmeldenummer: 17739514.2
(22) Anmeldetag: 03.07.2017
(51) Int. Cl.: H01L 21/687, C30B 25/12

(54) **VORRICHTUNG ZUR HANDHABUNG EINER HALBLEITERSCHEIBE IN EINEM EPITAXIE-REAKTOR UND VERFAHREN ZUR HERSTELLUNG EINER HALBLEITERSCHEIBE MIT EPITAKTISCHER SCHICHT**
APPARATUS VON HANDLING A SEMICONDUCTOR WAFER IN AN EPITAXY REACTOR AND METHOD FOR MANUFACTURING A SEMICONDUCTOR WAFER WITH AN EPITACTIC LAYER
APPAREIL POUR LA MANIPULATION D'UN SUBSTRAT SEMICONDUCTEUR DANS BÂTI D'ÉPITAXIE ET MÉTHODE DE FABRICATION D'UN SUBSTRAT SEMICONDUCTEUR AVEC UNE COUCHE ÉPITACTIQUE

(30) Priorität: 13.07.2016 DE 102016212780
(43) Veröffentlichungstag der Anmeldung: 22.05.2019
(73) Patentinhaber: Siltronic AG, 81737 München (DE)
(72) Erfinder: MOOS, Patrick, 84568 Pleiskirchen (DE); HECHT, Hannes, 84489 Burghausen (DE)
(74) Vertreter: Staudacher, Wolfgang
(86) Internationale Anmeldenummer: PCT/EP2017/066437
(87) Internationale Veröffentlichungsnummer: WO 2018/010986

(56) Entgegenhaltungen:
- JP-A- H07 263 523
- JP-A- 2002 231 794
- KR-A- 20140 089 106
- US-A1- 2003 015 141
- US-A1- 2004 241 992
- US-A1- 2005 000 450
- US-A1- 2006 219 178
- US-A1- 2010 101 491
- US-B1- 6 190 113
- US-B1- 6 435 798

## Beschreibung

Gegenstand der Erfindung ist eine Vorrichtung zur Handhabung einer Halbleiterscheibe in einem Epitaxie-Reaktor. Darüber hinaus betrifft die Erfindung ein Verfahren zur Herstellung einer Halbleiterscheibe mit epitaktischer Schicht, bei dem die Vorrichtung eingesetzt wird.

### Stand der Technik / Probleme

Das Abscheiden einer epitaktischen Schicht auf einer Halbleiterscheibe geschieht üblicherweise mittels CVD (chemical vapor deposition) in einem Epitaxie-Reaktor, häufig in einem Einzelscheiben-Reaktor.

US 2014/0 251 208 A1 und US 2010/0 086 784 A1 enthalten Beschreibungen von Einzelheiten solcher Epitaxie-Reaktoren. Ein elementarer Teil der Handhabung einer Halbleiterscheibe umfasst vor dem Abscheiden der epitaktischen Schicht das Ablegen der Halbleiterscheibe auf einem Suszeptor und nach dem Abscheiden der epitaktischen Schicht das Anheben der Halbleiterscheibe mit epitaktischer Schicht vom Suszeptor. Die dafür eingesetzte Vorrichtung umfasst neben dem Suszeptor eine Scheiben-Hebewelle und Scheiben-Hebestifte, eine Suszeptor-Tragwelle, Suszeptor-Tragarme und Suszeptor-Stützstifte.

Die Dokumente US2003/0015141-A1, US2004/0241992-A1, US6435798-B1 und US2010/0101491-A1 offenbaren ebenfalls Vorrichtungen mit Hebestiften zur Handhabung von Halbleiterscheiben.

Die Scheiben-Hebewelle hat am oberen Ende Ausleger, die sich seitwärts nach oben erstrecken und unter den Scheiben-Hebestiften enden. Beim Absenken und Anheben der Scheiben-Hebewelle werden die Scheiben-Hebestifte und eine gegebenenfalls auf den Stiften abgelegte Halbleiterscheibe beziehungsweise Halbleiterscheibe mit epitaktischer Schicht mit abgesenkt und mit angehoben. Die Scheiben-Hebestifte werden dabei durch Löcher geschoben, die sich in den Suszeptor-Tragarmen der Suszeptor-Tragwelle befinden, sowie durch Durchgangsbohrungen im Suszeptor. Nachteilig an der beschriebenen Vorrichtung ist, dass ihre Verwendung anfällig ist Partikel zu erzeugen, und die Partikel die Rückseite der Halbleiterscheibe, die dem Suszeptor zugewandt ist, kontaminieren. Die Partikel entstehen als Abrieb in Folge von Reibung zwischen den Scheiben-Hebestiften und den Innenflächen der Löcher in den Suszeptor-Tragarmen und der Durchgangsbohrungen im Suszeptor. Die Reibung ist besonders auch dem Umstand geschuldet, dass die Vorrichtung in einem breiten Temperaturbereich funktionstüchtig bleiben muss und Wärmeausdehnung bei hoher Temperatur zu berücksichtigen ist. Die Scheiben-Hebestifte sind auch dafür anfällig, aus der vertikalen Lage zu verkippen. In einer solchen Situation entstehen zusätzlich Partikel.

Aus dieser Problematik ergab sich die Aufgabenstellung der Erfindung.

Die Aufgabe der Erfindung wird gelöst durch eine Vorrichtung zur Handhabung einer Halbleiterscheibe in einem Epitaxie-Reaktor, umfassend
einen Suszeptor;
durch den Suszeptor führende Langlöcher;
eine Scheiben-Hebewelle;
Scheiben-Hebestifte, die durch die Langlöcher geführt sind;
eine Suszeptor-Tragwelle;
Suszeptor-Tragarme;
Suszeptor-Stützstifte;
Führungshülsen, die in den Suszeptor-Tragarmen verankert sind; und Führungselemente, die aus den Führungshülsen ragen und an oberen Enden Bohrungen aufweisen, in denen die Scheiben-Hebestifte stecken, und die mittels der Scheiben-Hebewelle zusammen mit den Scheiben-Hebestiften heb- und absenkbar sind.

Die Aufgabe wird des Weiteren gelöst durch ein Verfahren zur Herstellung einer Halbleiterscheibe mit epitaktischer Schicht, umfassend
das Bereitstellen einer erfindungsgemäßen Vorrichtung in einem Epitaxie-Reaktor; das Ablegen einer Halbleiterscheibe auf den Scheiben-Hebestiften;
das Ablegen der Halbleiterscheibe auf dem Suszeptor durch Absenken der Scheiben-Hebestifte;
das Abscheiden der epitaktischen Schicht auf der Halbleiterscheibe;
das Anheben der entstandenen Halbleiterscheibe mit epitaktischer Schicht vom Suszeptor durch Anheben der Scheiben-Hebestifte; und
das Entfernen der Halbleiterscheibe mit epitaktischer Schicht aus dem Epitaxie-Reaktor.

Die Verwendung der vorgeschlagenen Vorrichtung unterdrückt das Entstehen von Partikeln im Zuge des Absenkens der Halbleiterscheibe vom Suszeptor und des Anhebens der Halbleiterscheibe mit epitaktischer Schicht vom Suszeptor und vermeidet insbesondere, dass die Rückseite der Halbleiterscheibe oder die Rückseite der Halbleiterscheibe mit epitaktischer Schicht durch Partikel kontaminiert wird. Darüber hinaus werden Eigenschaften wie Rundlauf, radialer Schlag und Höhenschlag der Vorrichtung wegen deren Ausgestaltung minimiert.

Die Vorrichtung ist insbesondere so gestaltet, dass die Scheiben-Hebestifte linear geführt durch Langlöcher im Suszeptor bewegt werden. Partikelbildung durch Reibung wird unabhängig von der vorherrschenden Betriebstemperatur unterdrückt.

Mindestens drei Suszeptor-Tragarme werden vorzugsweise von einem einteiligen Element gebildet, das am oberen Ende der Suszeptor-Tragwelle befestigt ist. Besonders bevorzugt ist ein sternförmiges Element aus Quarz, das an die Suszeptor-Tragwelle geschraubt ist. Das sternförmige Element kann aber auch mehrteilig sein und Streben aus Quarz umfassen, die an die Suszeptor-Tragwelle montiert, beispielsweise geschraubt sind.

In den Suszeptor-Tragarmen sind Führungshülsen verankert, vorzugsweise geschraubt, so dass sie bei Bedarf einfach ausgetauscht werden können. Die Führungshülsen haben vorzugsweise geschliffene Innenflächen und bestehen vorzugsweise aus Quarz. Die mittlere Rauheit Ra der Innenflächen beträgt vorzugsweise nicht mehr als 0,4 µm. Die Führungshülsen und Führungselemente in den Führungshülsen, die aus den Führungshülsen an beiden Enden herausragen, bilden jeweils Lineargleitlager, die die linear geführte Bewegung der Scheiben-Hebestifte gewährleisten. Die stabförmigen Führungselemente bestehen aus demselben Material wie die Führungshülsen und haben Außenflächen, deren mittlere Rauheit Ra vorzugsweise ebenfalls nicht mehr als 0,4 µm beträgt. Zwischen den Führungshülsen und den Führungselementen findet daher kaum Reibung statt, so dass auch kaum Partikel entstehen, und wenn überhaupt, nur an einem Ort mit ausreichend Abstand zum Suszeptor und einer darauf liegenden Halbleiterscheibe, so dass eine Kontamination der Rückseite der Halbleiterscheibe durch Partikel ausgeschlossen ist. Insbesondere verhindert die Anordnung von Führungshülsen und Führungselementen und Langlöchern, dass beim Anheben und Absenken der Scheiben-Hebestifte Partikel in unmittelbarer Nähe der Halbleiterscheibe erzeugt werden. Darüber hinaus ist auch ein unabsichtliches Verkippen der Scheiben-Hebestifte aus der vertikalen Lage nicht möglich.

Die Scheiben-Hebestifte, die vorzugsweise obere Enden mit T-förmigem Querschnitt haben, stecken in Bohrungen der Führungselemente, die die Führungselemente an oberen Enden aufweisen. Die Scheiben-Hebestifte und die Bohrungen der Führungselemente sind vorzugsweise so dimensioniert, dass die Scheiben-Hebestifte zentriert werden, wenn sie bei Raumtemperatur in die Bohrungen der Führungselemente gesteckt werden. Gemäß einer bevorzugten Ausgestaltung sind die Scheiben-Hebestifte aus einem anderen Material mit anderer Wärmeausdehnung gefertigt, als die Führungselemente, vorzugsweise aus Siliziumcarbid. In diesem Fall sind die Fertigungstoleranzen der Scheiben-Hebestifte und der Führungselemente darüber hinaus so bemessen, dass bei Temperaturen, die beim Abscheiden der epitaktischen Schicht eingestellt werden, die Scheiben-Hebestifte mit den Führungselementen klemmend verbunden sind. Vorzugsweise entsteht die klemmende Verbindung bei Temperaturen von mehr als 900 °C. Wegen der klemmenden Verbindung haben die Scheiben-Hebestifte kein radiales Spiel, was zur Unterdrückung der Bildung von Partikeln beiträgt.

Diese Ausgestaltung gewährleistet auch, dass die Scheiben-Hebestifte und die Langlöcher im Suszeptor mindestens in einem Temperaturbereich, der sich von Raumtemperatur bis zur Abscheidetemperatur erstreckt, stets fluchtend ausgerichtet bleiben. Darüber hinaus ist so sichergestellt, dass die T-förmigen Enden der Scheiben-Hebestifte synchron auf dem Suszeptor abgelegt und vom Suszeptor abgehoben werden können.

Zur Bewegung der Scheiben-Hebestifte werden die Scheiben-Hebewelle und die Führungselemente, die auf äußeren Enden von Auslegern der Scheiben-Hebewelle aufliegen, angehoben oder abgesenkt.

Darüber hinaus sind Steherelemente an den äußeren Enden der Suszeptor-Tragarme höhenverstellbar befestigt, vorzugsweise angeschraubt. Die oberen Enden der Steherelemente weisen axiale Bohrungen auf, in denen Suszeptor-Stützstifte stecken, deren Köpfe vorzugsweise kugelförmig abgerundet sind. Auf der Rückseite des Suszeptors befinden sich Sacklöcher mit länglicher Grundfläche zur Aufnahme der kugelförmig abgerundeten Köpfe der Suszeptor-Stützstifte. Länge und Breite der Sacklöcher steigen in Richtung zur Öffnung der Sacklöcher an. Vorzugsweise bilden die Sacklöcher für die Suszeptor-Stützstifte eine Auflage mit prismenförmiger Kontur. Diese Ausgestaltung erlaubt eine reibungsarme radiale Bewegung des Suszeptors, insbesondere eine durch Wärmeausdehnung des Suszeptor-Materials ausgelöste selbstzentrierende Bewegung.

Der Suszeptor hat vorzugsweise einen tellerförmigen Querschnitt und umfasst eine als Sims (ledge) gestaltete ringförmige Ablagefläche und einen Suszeptor-Boden. Die Halbleiterscheibe liegt im Randbereich mit der Rückseite auf der ringförmigen Ablagefläche und hat einen geringen Abstand zum Suszeptor-Boden. Der Suszeptor kann einteilig gestaltet sein oder von einem Ring und einem flachen Suszeptor-Boden gebildet werden, wobei der Ring auf dem flachen Suszeptor-Boden liegt. Die Langlöcher und die Sacklöcher sind im Suszeptor-Boden angeordnet.

Die bezüglich der vorstehend aufgeführten Ausführungsformen des erfindungsgemäßen Verfahrens angegebenen Merkmale können entsprechend auf die erfindungsgemäße Vorrichtung übertragen werden. Umgekehrt können die bezüglich der vorstehend ausgeführten Ausführungsformen der erfindungsgemäßen Vorrichtung angegebenen Merkmale entsprechend auf das erfindungsgemäße Verfahren übertragen werden. Diese und andere Merkmale der erfindungsgemäßen Ausführungsformen werden in der Figurenbeschreibung und in den Ansprüchen erläutert. Die einzelnen Merkmale können entweder separat oder in Kombination als Ausführungsformen der Erfindung verwirklicht werden. Weiterhin können sie vorteilhafte Ausführungen beschreiben, die selbstständig schutzfähig sind.

### Kurzbeschreibung der Figuren

**Fig. 1** ist eine Schnittzeichnung durch eine Vorrichtung mit erfindungsgemäßen Merkmalen.
**Fig.2**, **Fig.3** und **Fig.4** zeigen einzelne Merkmale der Vorrichtung gemäß Fig.1 in vergrößerter Darstellung.

### Liste der verwendeten Bezugszeichen

- **1**: Suszeptor
- **2**: Scheiben-Hebewelle
- **3**: Scheiben-Hebestift
- **4**: Suszeptor-Tragwelle
- **5**: Suszeptor-Tragarm
- **6**: Suszeptor-Stützstift
- **7**: Führungshülse
- **8**: Führungselement
- **9**: Steherelement
- **10**: kugelförmig abgerundeter Kopf
- **11**: Langloch
- **12**: Sackloch

### Detaillierte Beschreibung eines erfindungsgemäßen Ausführungsbeispiels

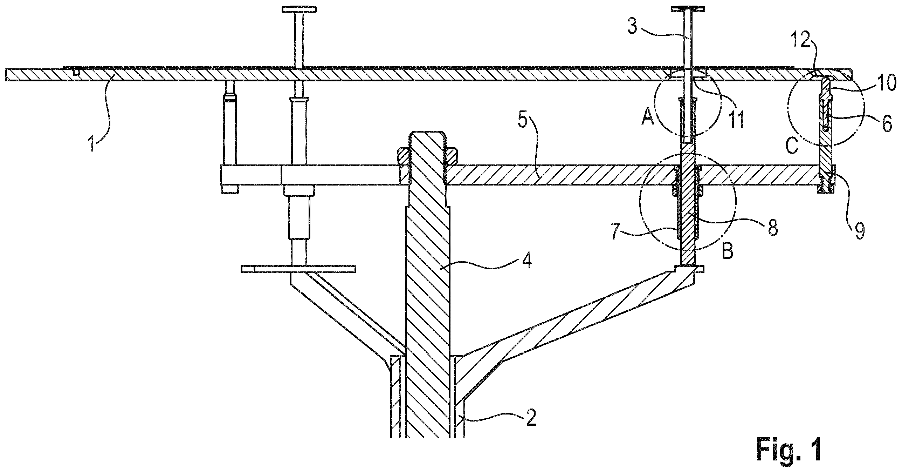

Die Vorrichtung gemäß Fig.1 umfasst eine Suszeptor-Tragwelle 4 und eine Scheiben-Hebewelle 2. Suszeptor-Tragarme 5 mit gleichen Abständen zueinander sind zu einem einteiligen sternförmigen Element zusammengefasst, das ans obere Ende der Suszeptor-Tragwelle 4 geschraubt ist. Die Scheiben-Hebewelle 2 umfasst radial nach oben wegstehende Ausleger, an deren Enden Plattformen zum Abstützen von Führungselementen 8 vorgesehen sind. Die Führungselemente 8 sind durch Führungshülsen 7 geschoben, die in den Suszeptor-Tragarmen 5 verankert sind. Die oberen Enden der Führungselemente 8 weisen Bohrungen auf, in denen Scheiben-Hebestifte 3 stecken. Die Scheiben-Hebestifte 3 erstrecken sich durch Langlöcher 11 im Suszeptor 1. Der Suszeptor 1 hat auf der Rückseite Sacklöcher 12 mit länglicher Grundfläche und liegt dort auf kugelförmig abgerundeten Köpfen 10 von Suszeptor-Stützstiften 6. Die Suszeptor-Stützstifte 6 stecken in axialen Bohrungen an oberen Enden von Steherelementen 9. Die Steherelemente 9 sind auf den Suszeptor-Tragarmen 5 an deren äußeren Enden höhenverstellbar befestigt.

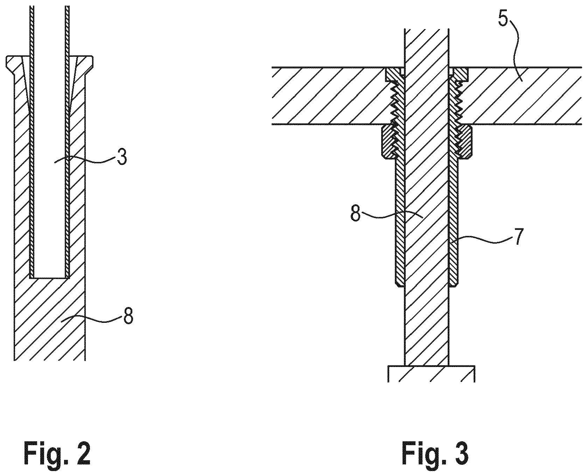

Fig.2 zeigt in vergrößerter Darstellung das obere Ende des Führungselements 8 mit der dort vorgesehenen Bohrung und das untere Ende des in die Bohrung gesteckten Scheiben-Hebestifts 3. Dieser Bereich ist in Fig.1 mit einem Kreis und dem Buchstaben A markiert.

Fig.3 zeigt in vergrößerter Darstellung die Führungshülse 7, die im Suszeptor-Tragarm 5 verankert ist und einen Teil des Führungselements 8, das durch die Führungshülse 7 geschoben ist und am unteren Ende auf einer Plattform des Auslegers der Scheiben-Hebewelle 2 steht. Dieser Bereich ist in Fig.1 mit einem Kreis und dem Buchstaben B markiert.

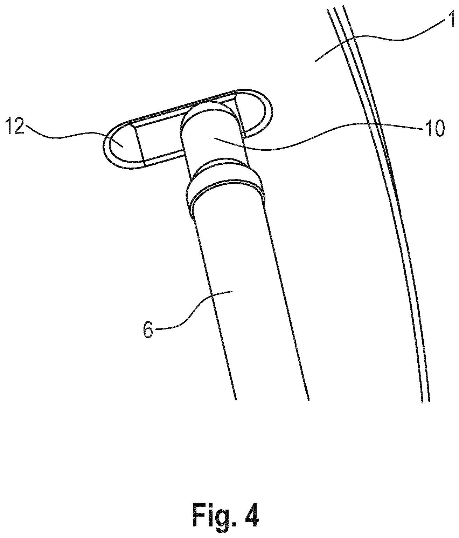

Fig.4 zeigt in vergrößerter Darstellung das obere Ende des Suszeptor-Stützstifts 6 und den kugelförmig abgerundeten Kopf 10 des Suszeptor-Stützstifts, der in das Sackloch 12 auf der Rückseite des Suszeptors 1 ragt. Dieser Bereich ist in Fig.1 mit einem Kreis und dem Buchstaben C markiert.

Die vorstehende Beschreibung einer beispielhaften Ausführungsform ist exemplarisch zu verstehen. Die damit erfolgte Offenbarung ermöglicht es dem Fachmann einerseits, die vorliegende Erfindung und die damit verbundenen Vorteile zu verstehen, und umfasst andererseits im Verständnis des Fachmanns auch offensichtliche Abänderungen und Modifikationen der beschriebenen Strukturen und Verfahren. Daher sollen alle derartigen Abänderungen und Modifikationen sowie Äquivalente durch den Schutzbereich der Ansprüche abgedeckt sein.

## Patentansprüche

1. Vorrichtung zur Handhabung einer Halbleiterscheibe in einem Epitaxie-Reaktor, umfassend einen Suszeptor (1); durch den Suszeptor führende Langlöcher (11); eine Scheiben-Hebewelle (2); Scheiben-Hebestifte (3), die durch die Langlöcher geführt sind; eine Suszeptor-Tragwelle (4); Suszeptor-Tragarme (5); Suszeptor-Stützstifte (6); Führungshülsen (7), die in den Suszeptor-Tragarmen verankert sind und Führungselemente (8), die aus den Führungshülsen ragen und an oberen Enden Bohrungen aufweisen, in denen die Scheiben-Hebestifte stecken, und die mittels der Scheiben-Hebewelle zusammen mit den Scheiben-Hebestiften heb- und absenkbar sind.

2. Vorrichtung nach Anspruch 1, **dadurch gekennzeichnet, dass** die Suszeptor-Tragarme ein einteiliges sternförmiges Element bilden, das ans obere Ende der Suszeptor-Tragwelle geschraubt ist.

3. Vorrichtung nach Anspruch 1 oder Anspruch 2, **dadurch gekennzeichnet, dass** die Führungselemente und die Scheiben-Hebestifte unterschiedliche Wärmeausdehnung haben und mit Toleranzen gefertigt sind, die derart bemessen sind, dass zwischen den Führungselementen und den Scheiben-Hebestiften bei Temperaturen von über 900 °C eine klemmende Verbindung entsteht.

4. Vorrichtung nach einem der Ansprüche 1 bis 3, **gekennzeichnet durch** Steherelemente (9), die mit den Suszeptor-Tragarmen an deren äußeren Enden höhenverstellbar verbunden sind und axiale Bohrungen aufweisen, in denen die Suszeptor-Stützstifte stecken, wobei die Suszeptor-Stützstifte kugelförmig abgerundete Köpfe haben.

5. Vorrichtung nach Anspruch 4, **gekennzeichnet durch** längliche Sacklöcher auf einer Rückseite des Suszeptors zur Aufnahme der kugelförmig abgerundeten Köpfe der Suszeptor-Stützstifte, wobei Länge und Breite der Sacklöcher in Richtung zur Öffnung der Sacklöcher ansteigen.

6. Verfahren zur Herstellung einer Halbleiterscheibe mit epitaktischer Schicht, umfassend
das Bereitstellen einer Vorrichtung nach einem der Ansprüche 1 bis 5 in einem Epitaxie-Reaktor;
das Ablegen einer Halbleiterscheibe auf den Scheiben-Hebestiften (3);
das Ablegen der Halbleiterscheibe auf dem Suszeptor durch Absenken der Scheiben-Hebestifte;
das Abscheiden der epitaktischen Schicht auf der Halbleiterscheibe;
das Anheben der entstandenen Halbleiterscheibe mit epitaktischer Schicht vom Suszeptor durch Anheben der Scheiben-Hebestifte; und
das Entfernen der Halbleiterscheibe mit epitaktischer Schicht aus dem Epitaxie-Reaktor.

7. Verfahren nach Anspruch 6, **gekennzeichnet durch** das Abscheiden einer epitaktischen Schicht aus Silizium auf einer Halbleiterscheibe aus einkristallinem Silizium.

## Claims

1. Device for handling a semiconductor wafer in an epitaxy reactor, comprising
a susceptor;
slots leading through the susceptor;
a disk heave shaft;
Disc lifting pins, which are guided through the oblong holes;
a susceptor support shaft;
susceptor support arms;
Susceptor support pins;
guide sleeves anchored in the susceptor support arms; and
Guide elements which protrude from the guide sleeves and have holes at the upper ends in which the disc lifting pins are inserted and which can be raised and lowered by means of the disc lifting shaft together with the disc lifting pins.

2. Device according to claim 1, **characterized in that** the susceptor support arms form a one-piece star-shaped element which is screwed to the upper end of the susceptor support shaft.

3. Device according to claim 1 or claim 2, **characterized in that** the guide elements and the disc lifting pins have different thermal expansion and are manufactured with tolerances which are dimensioned in such a way that a clamping connection is produced between the guide elements and the disc lifting pins at temperatures above 900°C.

4. Device according to one of claims 1 to 3, **characterized by** upright elements which are connected to the susceptor support arms at their outer ends in a height-adjustable manner and have axial bores in which the susceptor support pins are inserted, the susceptor support pins having spherically rounded heads.

5. the device according to claim 4, **characterized by** elongated blind holes on a rear side of the susceptor for receiving the spherically rounded heads of the susceptor support pins, the length and width of the blind holes increasing in the direction towards the opening of the blind holes.

6. Method of producing a semiconductor wafer with an epitaxial layer, comprising the provision of a device according to any one of claims 1 to 5 in an epitaxy reactor; placing of a semiconductor wafer on the wafer lifting pins;
depositing the wafer on the susceptor by lowering the wafer lifting pins;
deposition of the epitaxial layer on the semiconductor wafer;
lifting the resulting semiconductor wafer with epitaxial layer from the susceptor by lifting the wafer lifting pins; and
removal of the semiconductor wafer with epitaxial layer from the epitaxy reactor

7. Process according to claim 6, **characterised by** the deposition of an epitaxial layer of silicon on a semiconductor wafer of single-crystalline silicon.

## Revendications

1. Dispositif pour la manipulation d'une tranche de semi-conducteur dans un réacteur d'épitaxie, comprenant
un suscepteur; des
fentes conduisant au travers du suscepteur ;
un arbre à disques ;
Des goupilles de levage de disque, qui sont guidées à travers les trous oblongs;
un arbre de support de suscepteur; des
bras de support de suscepteur;
Tiges de support des susceptibilités;
des manchons de guidage ancrés dans les bras de support du suscepteur Éléments de guidage qui dépassent des douilles de guidage et qui présentent des trous aux extrémités supérieures dans lesquels sont insérés les goupilles de levage du disque et qui peuvent être levés et abaissés au moyen de l'arbre de levage du disque avec les goupilles de levage du disque.

2. Dispositif selon la revendication 1, **caractérisé en ce que** les bras de support du suscepteur forment un élément monobloc en forme d'étoile qui est vissé à l'extrémité supérieure de l'arbre de support du suscepteur.

3. Dispositif selon la revendication 1 ou la revendication 2, **caractérisé en ce que** les éléments de guidage et les goupilles de levage de disque ont une dilatation thermique différente et sont fabriqués avec des tolérances qui sont dimensionnées de telle sorte qu'une liaison par serrage est produite entre les éléments de guidage et les goupilles de levage de disque à des températures supérieures à 900°C.

4. Dispositif selon l'une des revendications 1 à 3, **caractérisé par** des éléments verticaux qui sont reliés aux bras de support de suscepteur à leurs extrémités extérieures de manière réglable en hauteur et qui présentent des alésages axiaux dans lesquels sont insérés les axes de support de suscepteur, les axes de support de suscepteur présentant des têtes sphériques arrondies.

5. Dispositif selon la revendication 4, **caractérisé par** des trous borgnes allongés sur un côté arrière du suscepteur pour recevoir les têtes sphériques arrondies des broches de support du suscepteur, la longueur et la largeur des trous borgnes augmentant dans la direction de l'ouverture des trous borgnes.

6. Procédé de fabrication d'une plaquette semi-conductrice avec une couche épitaxiale, comprenant
la fourniture d'un dispositif conforme à l'une des revendications 1 à 5 dans un réacteur d'épitaxie;
la pose d'une plaquette de semi-conducteur sur les tiges de levage de la plaquette ; déposer la plaquette sur le suscepteur en abaissant les tiges de levage de la plaquette;
le dépôt de la couche épitaxiale sur la plaquette semi-conductrice ;
soulever la plaquette de semi-conducteur avec couche épitaxiale résultante du suscepteur en soulevant les broches de levage de la plaquette
l'enlèvement de la plaquette de semi-conducteur avec couche épitaxiale du réacteur d'épitaxie

7. Procédé selon la revendication 6, **caractérisé par** le dépôt d'une couche épitaxiale de silicium sur une plaquette semi-conductrice de silicium monocristallin.
